# EUROPÄISCHE PATENTSCHRIFT

(11) **EP 0 390 827 B1**
(45) Veröffentlichungstag und Bekanntmachung des Hinweises auf die Patenterteilung: **23.03.1994**
(21) Anmeldenummer: 89900227.3
(22) Anmeldetag: 07.12.1988
(51) Int. Cl.: H05K 3/42, C25D 5/54

(54) **VERFAHREN ZUR HERSTELLUNG DURCHKONTAKTIERTER LEITERPLATTEN**
PROCESS FOR MANUFACTURING THROUGH-CONTACTING PRINTED CIRCUIT BOARDS
PROCEDE DE FABRICATION DE PLAQUETTES DE CIRCUITS IMPRIMES A PASSAGES DEBOUCHANTS POUR CONTACTS

(30) Priorität: 08.12.1987 DE 3741459
(43) Veröffentlichungstag der Anmeldung: 10.10.1990
(73) Patentinhaber: Blasberg-Oberflächentechnik GmbH, D-42699 Solingen (DE)
(72) Erfinder: HUPE, Jürgen, D-4018 Langenfeld (DE); IWAN, Herbert, D-5650 Solingen 11 (DE)
(74) Vertreter: Werner, Hans-Karsten, Dr.Dipl.-Chem.
(86) Internationale Anmeldenummer: EP8801112
(87) Internationale Veröffentlichungsnummer: WO8905568

(56) Entgegenhaltungen:
- EP-A- 0 248 683
- DE-A- 3 304 004
- GB-A- 2 123 036
- US-A- 3 099 608
- US-A- 4 622 108

## Beschreibung

Gegenstand der vorliegenden Erfindung ist ein Verfahren zur Herstellung durchkontaktierter Leiterplatten durch direkte galvanische Metallabscheidung auf katalytisch aktivierten Oberflächen des Basismaterials unter Verwendung bekannter galvanischer Bäder, wobei die katalytisch aktivierten Oberflächen vor der galvanischen Metallabscheidung verbehandelt werden.

In der Praxis werden bisher durchkontaktierte Leiterplatten nicht durch direkte galvanische Metallabscheidung, sondern durch chemische Metallabscheidung auf katalytisch aktivierten Oberflächen des Basismaterials hergestellt. Diese chemisch niedergeschlagenen Metallschichten werden gegebenenfalls später durch galvanische Metallabscheidung verstärkt. Diese Technologie hat sich durchaus bewährt und führt zu qualitativ hochwertigen Leiterplatten. Dennoch weist diese Technologie einige Nachteile auf, die bisher jedoch in Ermangelung von praktikablen Alternativen in Kauf genommen werden müssen. Es ist vor allem die außenstromlose und somit rein chemische Metallablagerung in Reduktionsbädern, die sehr aufwendig ist und eine genaue Badanalytik und Badführung notwendig macht. Diese chemischen Metallisierungsbäder enthalten auch mit Abstand die teuersten Chemikalien. Dennoch sind die derartig abgeschiedenen Schichten physikalisch und mechanisch von geringerer Qualität als galvanisch abgeschiedene Metallschichten. Ein weiterer Nachteil der bisher angewendeten Technologie ist die Unsicherheit bei der Stabilisierung der Systeme und damit auch der Gewißheit, daß die Abscheidungsgeschwindigkeit und Schichtdicke in den Bohrlochwandungen ausreichend reproduzierbar ist. Diese Bäder enthalten obendrein als Reduktionsmittel meistens Formaldehyd, der inzwischen als gesundheitlich bedenklich anzusehen ist. Diese chemischen Metallisierungsbäder enthalten weiterhin größere Mengen von Komplexbildnern, die biologisch schwer abbaubar sind und deshalb eine erhebliche Belastung der Abwässer darstellen.

Es ist deshalb schon seit langem versucht worden, auf diese chemische Metallisierung zu verzichten und statt dessen eine direkte galvanische Metallabscheidung durchzuführen. Ein derartiges Verfahren ist beispielsweise in der US-PS 3,099,608 beschrieben worden sowie in der DE-OS 33 04 004. Diese Verfahren haben jedoch keinen Eingang in die Praxis gefunden. Eine Nacharbeitung dieser Verfahren durch die Anmelderin hat ergeben, daß nur mit frisch zubereiteten galvanischen Metallisierungsbädern einigermaßen brauchbare Ergebnisse erzielt werden können. Schon sehr rasch nach Inbetriebnahme eines derartigen galvanischen Metallisierungsbades sinkt die Qualität der erhaltenen Metallablagerungen derartig, daß nur noch unbrauchbare Ergebnisse erzielt werden. Weiterhin wurde die Beobachtung aus der US-PS 3,099,608 bestätigt, daß relativ lange Zeiten für die Metallablagerung notwendig sind, nämlich mindestens 20 Minuten. Vor allem treten aber sehr rasch in zunehmenden Maße Fehlstellen bei der Metallisierung auf und werden Metallschichten auf der Lochwandung erhalten, die ungenügend daran haften.

GB-A-2 123 036 beschreibt ein Verfahren zur galvanischen Metallabscheidung auf nicht-metallischen Oberflächen, bei dem das Galvanisierungsbad eine Komponente C enthält, die eine verbesserte galvanische Metallabscheidung gewährleisten soll. Dabei handelt es sich bei dieser Komponente um Farbstoffe, oberflächenaktive Stoffe (Benetzer), Chelate, Glanz- und Nivellierungszusätze.

Die Erfindung hat sich die Aufgabe gestellt, ein Verfahren zur Herstellung durchkontaktierter Leiterplatten durch direkte galvanische Metallabscheidung auf katalytisch aktivierten Oberflächen des Basismaterials zu entwickeln, welches rasch und preiswert zu Produkten führt, die qualitativ mit den bisher bekannten Produkten vergleichbar sind und bei denen die Metallisierungsbäder über eine ausreichend lange Zeit verwendet werden können.

Diese Aufgabe kann überraschend einfach dadurch gelöst werden, daß die Vorbehandlung mit einer Lösung erfolgt, die eine oder mehrere stickstoffhaltige organische Verbindungen enthält wobei die Oberflächen während oder nach der Vorbehandlung mit der stickstoffhaltigen organischen Verbindung enthaltenden Lösung, aber vor der galvanischen Metallabscheidung, kurzfristig als Anode oder Kathode geschaltet werden. Als stickstoffhaltige organische Verbindungen können beispielsweise gegebenenfalls durch Hydroxyl-, Carboxyl- oder Sulfogruppen substituierte aliphatische, aromatische, heterocyclische oder cycloaliphatische Mono-, Di- oder Polyamine sowie ein- oder mehrkernige N-haltige heterocyclische Verbindungen verwendet werden, die gegebenenfalls in ethoxilierter, propoxilierter und/oder quaternisierter Form oder in Form eines Säureadditionssalzes vorliegen.

Besonders gute Ergebnisse wurden bisher gefunden mit Polyvinylpyrrolidonen, 2,2,6,6-Tetramethyl-4-piperidon, Pyridiniumpropylsulfobetain und/oder polymeren, polyquaternären Ammoniumchloriden.

Die Wirksamkeit der genannten Verbindungen kann durch die zusätzliche Verwendung von Reduktionsmitteln, wie z.B. Borhydrid, Ascorbinsäure, Oxalsäure, Hypophosphit u.a., noch weiter gesteigert werden. Die Reduktionsmittel können gegebenenfalls auch separat als Vorstufe vor der Vorbehandlung eingesetzt werden.

Es gibt bisher noch keine Erklärung für die Wirkung der stickstoffhaltigen organischen Verbindungen und der kurzfristigen Schaltung als Anode oder Kathode.

Ganz offensichtlich werden aber durch diese Maßnahmen die katalytisch aktivierten Oberflächen in einer Weise verändert, daß sie in der Lage sind, wesentlich rascher, reproduzierbarer und haltbarer eine direkte galvanische Metallabscheidung zu gewährleisten. Weiterhin haben diese Maßnahmen die Folge, daß die anschließend eingesetzten galvanischen Metallbäder über einen langen Zeitraum ohne Beeinträchtigung der Qualität eingesetzt werden können.

Schließlich wurde festgestellt, daß eine weitere Optimierung der Verfahrensbedingungen erreicht werden kann, wenn während der Vorbehandlung mit der stickstoffhaltigen organischen Verbindung enthaltenden Lösung und/oder während der galvanischen Metallabscheidung Ultraschall zur Einwirkung kommt. Die Wirkung von Ultraschall beruht wahrscheinlich auf einer verbesserten Hydrodynamik an der Oberfläche, jedoch gibt es bisher keinen exakten Beweis für diese Annahme.

Zur Durchführung des erfindungsgemäßen Verfahrens kann man von den üblichen Basismaterialien ausgehen. Hierzu gehören insbesondere glasfaserverstärktes Epoxidharz, Polyimid und andere feste Polymere. Prinzipiell sind alle Basismaterialien geeignet, die mit einer Metallschicht überziehbar sind, indem sie katalytisch aktiviert werden.

Auch die katalytische Aktivierung der Oberflächen erfolgt in an sich bekannter Weise. Insbesondere erfolgt die Aktivierung mittels edelmetallhaltiger, kolloidaler, ionogener oder nicht ionogener Katalysatoren, insbesondere die bekannten Katalysatoren auf Basis von Palladium und Zinn. Prinzipiell sind aber auch andere, beispielsweise nicht edelmetallhaltige Katalysatoren geeignet oder aufgedampfte, katalytisch wirkende Schichten.

Auch die anschließende galvanische Metallabscheidung erfolgt mittels bekannter galvanischer Bäder. Es können prinzipiell alle Metalle bzw. Legierungen abgeschieden werden, die auf galvanischem Wege abzuscheiden sind. Bevorzugt werden jedoch Kupferelektrolyte verwendet. Besonders bevorzugt sind schwefelsaure Kupferbäder mit einem Gehalt von 50 bis 300 g/l freier Schwefelsäure und einem Metallgehalt von 5 bis 50 g/l. Aber auch fluorborsaure, salzsaure, thiosulfat- oder pyrophosphathaltige oder cyanidische Elektrolyte sowie Elektrolyte auf Basis von Sulfaminen und organischen Sulfonsäuren haben sich als geeignet erwiesen.

Elektrolyte werden unter den üblichen Bedingungen, nämlich im Temperaturbereich zwischen 20 und 70°C mit Stromdichten zwischen 0,1 und 20 A/dm² betrieben. Überraschenderweise kann die Zeit der galvanischen Abscheidung erheblich verkürzt werden, nämlich in besonders günstigen Fällen auf 2 bis 5 Minuten. Man erhält gleichmäßige, geschlossene und darüber hinaus fest haftende Metallschichten, die auch im sogenannten Durchlichttest keinerlei Fehlstellen aufweisen.

Die erfindungsgemäß hergestellten durchkontaktierten Schaltungen können in bekannter Weise weiterverarbeitet werden. So kann beispielsweise ein weiterer Aufbau von metallischen Schichten auf galvanischem Wege erfolgen, so daß Kupferschichten von 25 bis 40 µm Dicke entstehen, die anschließend mit weiteren metallischen Schichten belegt werden, die als Ätzresiste wirken. Es ist mit Hilfe des erfindungsgemäßen Verfahrens auch möglich, die durchkontaktierten Leiterplatten zunächst negativ mit einem Sieb- oder Photodruck zu belegen, um nach dem Belichten und Entwickeln das Leiterbild zu erzeugen. Es erfolgt dann erst anschließend der Leiterbildaufbau. Schließlich ist es möglich, das Leiterbild nach der katalytischen Aktivierung des gebohrten Basismaterials selektiv mittels Sieb- oder Photodruck herzustellen, um anschließend selektiv auf den freiliegenden, bereits aktivierten Flächen galvanisch zu metallisieren. Hierbei wird ein direkter Aufbau der Leiterplatte erreicht.

Die erfindungsgemäße Vorbehandlung erfolgt insbesondere mit Hilfe von wässrigen Lösungen oder Lösungen in organischen Lösungsmitteln der stickstoffhaltigen organischen Verbindungen und gegebenenfalls des Reduktionsmittels. Diese Lösungen weisen meistens Konzentrationen von 1 bis 250 g/l auf. Es genügen meistens wenige Vorversuche, um die für das jeweils katalytisch aktivierte Basismaterial optimalen Bedingungen zu ermitteln. Der zusätzliche Verfahrensschritt der Vorbehandlung erfordert nur einen geringen Aufwand, der kostenmäßig in keiner Relation zu dem erzielten verbesserten Ergebnis steht - auch im Vergleich zu der bisher in der Praxis bewährten Methode der chemischen Metallabscheidung.

In den nachfolgenden Beispielen und Vergleichsbeispielen ist das erfindungsgemäße Verfahren näher erläutert:

### Vergleichsbeispiel 1

Ein doppelseitig kupferkaschiertes Substrat aus glasfaserverstärktem Epoxidharz wird in üblicher Weise gebohrt, mechanisch gereinigt und chemisch in einem handelsüblichen Reiniger (Blasolit® MSH) entfettet. Anschließend wird das Substrat mit einer wässrigen Lösung von Wasserstoffperoxid und Schwefelsäure angeätzt. Danach wird in einer etwa 10%-igen Salzsäurelösung dekapiert und anschließend mit einem handelsüblichen Katalysatorsystem auf Basis von kolloidalem Palladium (Katalysatorlösung K 125 der Anmelderin) aktiviert. Es wird mit Wasser gespült und danach 2 Minuten lang in eine wässrige Lösung getaucht, die 10 g/l Polvinylpyrrolidon (K 30) enthält. Anschließend wurde mit 20%-iger Schwefelsäure dekapiert und mit einem handelsüblichen galvanischen Kupferelektrolytbad verkupfert. Als Elektrolyt wurde das Handelsprodukt der Anmelderin CUPRO-STAR® LP-1 verwendet. Dieser Elektrolyt hatte folgende Zusammensetzung:

| | |
|---|---|
| Kupfer: | 18 bis 22 g/l |
| Schwefelsäure: | 180 bis 250 g/l |
| Natriumchlorid: | 60 bis 100 mg/l |
| Zusatzmittel auf Basis eines Polyethers | 4 ml/l |

Die Temperatur betrug 20 bis 25°C und die Stromdichte 2 bis 4 A/dm². Bereits nach 15 Minuten waren alle Bohrungen vollständig, gleichmäßig und haftfest metallisiert.

### Vergleichsbeispiel 2

Unter den gleichen Bedingungen wie im Vergleichsbeispiel 1 wurde ohne die Vorbehandlung mit Polyvinylpyrrolidon direkt nach der Aktivierung galvanisch verkupfert. Nach 20 Minuten war nur ein Teil der Bohrungen metallisiert. Alle Bohrungen wiesen nicht metallisierte Stellen auf. Die Qualität der Ergebnisse sank sehr rasch mit zunehmendem Alter des Metallisierungsbades.

### Beispiel 1

Unter den gleichen Bedingungen wie im Vergleichsbeispiel 1 wurde konditioniert, jedoch während der Vorbehandlung wurde das Substrat als Anode geschaltet, so daß während 3 Minuten eine Spannung von ca. 10 V vorhanden war.

Anschließend wurde wie im Vergleichsbeispiel 1 galvanisch verkupfert. Bereits nach 4,5 Minuten waren alle Bohrungen vollständig und gleichmäßig haftfest mit Kupfer überzogen.

### Beispiel 2

In analoger Weise wie im Vergleichsbeispiel 1 beschrieben wurde die aktivierte Leiterplatte mit einer wässrigen Lösung von 20 g/l eines polymeren, polyquaternären Ammoniumchlorids vorbehandelt (Mirapol WT der Firma Miranol Chemical Company). Nach der Vorbehandlung wurde das Basismaterial 3 Minuten lang in eine 20%-ige H₂SO₄-Lösung eingetaucht und anodisch mit einer Spannung von ca. 5 V behandelt. Danach wurde gespült und galvanisch verkupfert. Bereits nach 3 Minuten waren alle Bohrungen vollständig, gleichmäßig und haftfest metallisiert.

### Beispiel 3

In analoger Weise wie in Beispiel 1 beschrieben wurde mit 1%-igen Lösungen von 2,2,6,6-Tetramethyl-4-piperidon, Hydrochlorid oder Pyridiniumpropylsulfobetain konditioniert. Nach jeweils ca. 4 Minuten waren alle Bohrungen vollständig, gleichmäßig und haftfest metallisiert.

### Beispiel 4

Das Beispiel 2 wurde wiederholt, jedoch wurde während der Konditionierung und der galvanischen Verkupferung Ultraschall angewendet. Bereits nach 2,5 Minuten waren alle Bohrungen vollständig, gleichmäßig und haftfest metallisiert.

Weitere Versuche haben ergeben, daß die so erhaltenen Kupferschichten von ca. 25 bis 40 µm Dicke ohne weiteres galvanisch mit weiteren metallischen Schichten belegt und somit weiterbehandelt werden konnten wie die bisher erhaltenen Produkte, bei denen die erste Kupferschicht chemisch niedergeschlagen worden war. Die physikalischen Eigenschaften der erfindungsgemäß hergestellten Kupferschichten waren jedoch deutlich besser als die von Schichten, die auf chemischem Weg aufgebaut waren.

### Vergleichsbeispiel 3

In analoger Weise wie in Beispiel 1 beschrieben wurde mit 1%-igen Lösungen von stickstofffreien Verbindungen wie zum Beispiel Hydrochinon oder ethoxilierten Alkylphenolen (Triton® BG 10, Rohm & Haas) vorbehandelt. Nach jeweils 8 Minuten waren alle Bohrungen vollständig, gleichmäßig und haftfest metallisiert.

## Patentansprüche

1. Verfahren zur Herstellung durchkontaktierter Leiterplatten durch direkte galvanische Metallabscheidung auf katalytisch aktivierten Oberflächen des Basismaterials unter Verwendung bekannter galvanischer Bäder, wobei die katalytisch activierten Oberflächen vor der galvanischen Mettallabscheidung Vorbehandelt werden, dadurch gekennzeichnet, daß die Vorbehandlung mit einer Lösung erfolgt, die eine oder mehrere stickstoffhaltige organische Verbindungen enthält, wobei die Oberflächen während oder nach der Vorbehandlung mit der stickstoffhaltigen organischen Verbindung enthaltenden Lösung, aber vor der galvanischen Metallabscheidung, kurzfristig als Anode oder Kathode geschaltet werden.

2. Verfahren gemäß Anspruch 1, dadurch gekennzeichnet, daß als stickstoffhaltige organische Verbindung ein gegebenenfalls durch Hydroxyl-, Carboxyl- oder Sulfogruppen substituiertes aliphatisches, aromatisches, heterocyclisches oder cycloaliphatisches Mono-, Di- oder Polyamin sowie ein- oder mehrkernige N-haltige heterocyclische Verbindungen verwendet werden, gegebenenfalls in ethoxilierter, propoxilierter und/oder quaternisierter Form oder in Form eines Säureadditionssalzes.

3. Verfahren gemäß Anspruch 1 oder 2, dadurch gekennzeichnet, daß als stickstoffhaltige organische Verbindung ein Polyvinylpyrrolidon, 2,2,6,6-Tetramethyl-4-piperidon, Pyridiniumpropylsulfobetain und/oder ein polymeres, polyquaternäres Ammoniumchlorid verwendet wird.

4. Verfahren gemäß einem der Ansprüche 1 bis 3, dadurch gekennzeichnet, daß die Vorbehandlung in Gegenwart von Reduktionsmitteln durchgeführt wird.

5. Verfahren gemäß einem der Ansprüche 1 bis 3, dadurch gekennzeichnet, daß vor der Vorbehandlung Reduktionsmittel eingesetzt werden.

6. Verfahren gemäß einem der Ansprüche 4 oder 5, dadurch gekennzeichnet, daß als Reduktionsmittel Borhydrid, Ascorbinsäure, Oxalsäure und/oder Hypophosphit eingesetzt werden.

7. Verfahren gemäß einem der Ansprüche 1 bis 6, dadurch gekennzeichnet, daß man während der Vorbehandlung und/oder während der galvanischen Metallabscheidung Ultraschall einwirken läßt.

## Claims

1. A process for manufacturing through-hole plated printed circuit boards by direct metal electrodeposition on catalytically activated surfaces of the substrate material using known plating baths, wherein the catalytically activated surfaces are pre-treated prior to electrodepositing the metal, characterized in that the pre-treatment is effected with a solution containing one or more nitrogen-containing organic compounds, while the surfaces are wired as an anode or cathode for a short period during or after the pre-treatment with the nitrogen-containing organic compounds, but prior to electrodepositing the metal.

2. The process according to claim 1, characterized in that there are used as the nitrogen-containing organic compounds aliphatic, aromatic, heterocyclic or cycloaliphatic mono-, di- or polyamines as well as mono- or polynuclear N-containing heterocyclic compounds, all of which may optionally be substituted with hydroxyl, carboxyl or sulfo groups, and which optionally are present in ethoxylated, propoxylated and/or quaternized form or in the form of an acid addition salt.

3. The process according to claim 1 or 2, characterized in that there is used as the nitrogen-containing organic compound a polyvinylpyrrolidone, 2,2,6,6-tetramethyl-4-piperidone, pyridiniumpropyl sulfo-betaine and/or a polymeric poly-quaternary ammonium chloride.

4. The process according to anyone of claims 1 to 3, characterized in that the pre-treatment is carried out in the presence of reducing agents.

5. The process according to anyone of claims 1 to 3, characterized in that reducing agents are employed prior to the pre-treatment.

6. The process according to anyone of claims 4 or 5, characterized in that as the reducing agents there are employed boron hydride, ascorbic acid, oxalic acid, and/or hypophosphite.

7. The process according to anyone of claims 1 to 6, characterized in that ultrasonic action is allowed to take place during the pre-treatment and/or during the electrodeposition of the metal.

## Revendications

1. Procédé de fabrication de plaquettes conductrices à trous métallisés, par dépôt électrolytique direct de métal sur des surfaces activées catalytiquement du matériau de base en utilisant des bains électrolytiques connus, les surfaces activées catalytiquement étant préalablement traitées avant le dépôt électrolytique de métal, caractérisé en ce qu'on effectue le traitement préalable avec une solution qui contient un ou plusieurs composés organiques azotés, les surfaces étant connectées en tant qu'anode ou cathode, pendant un bref instant, pendant ou après le traitement préalable avec la solution contenant des composés organiques azotés, mais avant le dépôt électrolytique de métal.

2. Procédé selon la revendication 1, caractérisé en ce qu'on utilise, comme composé organique azoté, une mono-, di- ou polyamine aliphatique, aromatique, hétérocyclique ou cycloaliphatique, éventuellement substituée par des groupes hydroxyles, carboxyles ou sulfo, ainsi que des composés hétérocycliques azotés mono- ou polynucléaires, éventuellement sous une forme éthoxylée, propoxylée et/ou quaternisée, ou sous la forme d'un sel d'addition d'acides.

3. Procédé selon la revendication 1 ou 2, caractérisé en ce qu'on utilise, comme composé organique azoté, la polyvinylpyrrolidone, la 2,2,6,6-tétraméthyl-4-pipéridone, la pyridiniumpropylsulfobétaïne et/ou un chlorure d'ammonium polymère polyquaternaire.

4. Procédé selon une des revendications 1 à 3, caractérisé en ce qu'on effectue le traitement préalable en présence d'agents réducteurs.

5. Procédé selon une des revendications 1 à 3, caractérisé en ce qu'on utilise des agents réducteurs. avant le traitement préalable.

6. Procédé selon la revendication 4 ou 5, caractérisé en ce qu'on utilise, comme agents réducteurs, l'hydrure de bore, l'acide ascorbique, l'acide oxalique et/ou un hypophosphite.

7. Procédé selon une des revendications 1 à 6, caractérisé en ce qu'on fait agir des ultrasons pendant le traitement préalable et/ou pendant le dépôt électrolytique de métal.
